# EUROPEAN PATENT APPLICATION

(11) **EP 4 376 049 A1**
(43) Date of publication of application: **29.05.2024**
(21) Application number: 22209971.5
(22) Date of filing: 28.11.2022
(51) Int. Cl.: H01J 37/28, G06T 7/00, H01J 37/22

(54) **CHARGED PARTICLE ASSESSMENT METHOD AND SYSTEM**

(71) Applicant: ASML Netherlands B.V., 5500 AH Veldhoven (NL)
(72) Inventor: DAVE, Dhara, 5500 AH Veldhoven (NL); KUIPER, Vincent, Sylvester, 5500 AH Veldhoven (NL)
(74) Representative: ASML Netherlands B.V.

(57) **Abstract**

A charged particle assessment method for identifying candidate defects in samples by scanning a charged particle beam across a sample; the method comprising:
obtaining a first reference image from a first region of the sample and a second reference image from a second region of the sample using a charged particle assessment apparatus;
obtaining a sample image from a third region of the sample using the charged particle assessment apparatus; and
comparing the sample image to the first reference image and to the second reference image to identify any candidate defects in the third region;
wherein the first reference image and/or the second reference image are obtained with a higher fidelity than the sample image.

## Description

### FIELD

The embodiments provided herein generally relate to charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection apparatuses with a charged particle beam have been used to inspect objects, which may be referred to as samples, for example to detect pattern defects. These apparatuses typically use electron microscopy techniques, such as a scanning electron microscope (SEM). In some SEMs, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample.

When a pattern inspection apparatus is used to detect defects on samples at a high throughput, there may be significant levels of noise in the image data. US 8,712,184 Bland US 9,436,985 B1 describe methods of reducing noise or improving signal-to-noise ratio in images obtained from scanning electron microscopes. Nevertheless, further improvements in increasing throughput and/or reducing noise or the effects of noise are desired.

### SUMMARY

It is an object of the present disclosure to provide embodiments that enable throughput to be increased without, or with less, increase in noise or the effects of noise in images, in particular reference images.

According to a first aspect of the invention, there is provided a charged particle assessment method for identifying candidate defects in samples by scanning a charged particle beam across a sample; the method comprising:
obtaining a first reference image from a first region of the sample and a second reference image from a second region of the sample using a charged particle assessment apparatus;
obtaining a sample image from a third region of the sample using the charged particle assessment apparatus; and
comparing the sample image to the first reference image and to the second reference image to identify any candidate defects in the third region;
wherein the first reference image and/or the second reference image are obtained with a higher fidelity than the sample image.

According to a second aspect of the invention, there is provided a charged particle assessment method for identifying candidate defects in samples by scanning a charged particle beam across a sample; the method comprising:
obtaining a reference image from a first region (desirably a reference region) of a sample using a charged particle assessment apparatus;
obtaining a sample image from a second region (desirably a sample region) of the sample using the charged particle assessment apparatus;
comparing the sample image to the reference image to determine if there might be a defect in the sample region;
generating a new reference image by combining the sample image and the reference image;
obtaining a further sample image from a further region of the sample using the charged particle assessment apparatus; and
comparing the further sample image to the new reference image to determine if there might be a defect in the further region.

According to a third aspect of the invention, there is provided a charged particle assessment method for detecting defects in samples by scanning a charged particle beam across a sample; the method comprising:
obtaining a reference image from a first region of a sample using a charged particle assessment apparatus;
obtaining a sample image from a second region of the sample using the charged particle assessment apparatus;
comparing the sample image to the reference image to identify any candidate defects in the sample region;
wherein the reference image is obtained with a higher fidelity than the sample image.

According to a fourth aspect of the invention, there is provided a computer program for controlling a charged particle assessment apparatus, the computer program comprising instructions that, when executed by the charged particle assessment apparatus, cause the charged particle assessment apparatus to perform a method as described above.

According to a fifth aspect of the invention, there is provided a charged particle assessment apparatus for identifying candidate defects in a sample by scanning a charged particle beam across the sample; the apparatus comprising:
a detector unit configured to output a digital detection signal of pixel values in response to signal particles incident from the sample;
a scanning unit for relatively scanning the sample and the charged particle beam;
a controller configured to control the detector unit and the scanning unit to obtain a first reference image from a first region of a sample and a second reference image from a second region of the sample and to obtain a sample image from a third region of the sample; and
a comparator configured to compare the sample image to the first reference image and to the second reference image to identify any candidate defects in the third region;
wherein the first reference image and/or the second reference image are obtained with a higher fidelity than the sample image.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection system.
**FIG. 2** is a schematic diagram illustrating an exemplary multi-beam charged particle assessment apparatus that is part of the exemplary charged particle beam inspection system of **FIG. 1****.**
**FIG. 3** is a flow diagram illustrating an exemplary method for assessing samples.
**FIG. 4** is a flow diagram of a method for obtaining a reference image according to an embodiment.
**FIG. 5** is a flow diagram of a method for obtaining a reference image according to an embodiment.
**FIG. 6** is a flow diagram of a method for updating a reference image according to an embodiment.
**FIG. 7** is a diagram of a data processing system according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

An embodiment of a SEM comprises a scanning device and a detector apparatus. The scanning device comprises an illumination apparatus that comprises an electron source, for generating primary electrons (or charged particles), and a projection apparatus for scanning a sample, such as a substrate, with one or more focused beams (or a plurality of beams) of primary electrons. The plurality of beams may be arranged as a multi-beam. The plurality of beams may have a multi-beam arrangement (which may have the form of a grid) which may be directed along a multi-beam path towards a sample. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

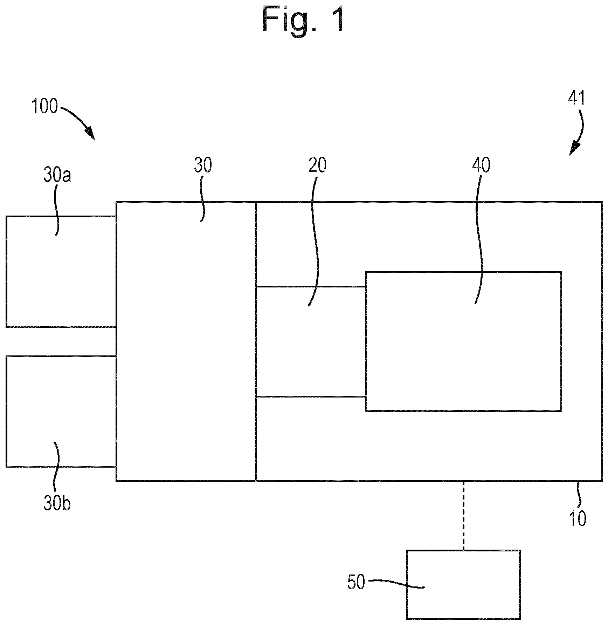

Reference is now made to **FIG. 1****,** which is a schematic diagram illustrating an exemplary charged particle beam assessment system 100 (or simply an assessment system), which may also be referred to as a charged particle beam inspection system or simply inspection system or a charged particle metrology system or simply a metrology system. The charged particle beam assessment system 100 of **FIG. 1** includes a main chamber 10, a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus (which may be referred to an electron-optical column or device).

The controller 50 is electronically connected to electron beam system 40. The controller 50 may be a processor (such as a computer) configured to control the charged particle beam assessment apparatus 100. The controller 50 may also include circuitry which may be referred to as processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure. For example the controller may be a distributed controller having one or more parts at the second pressure, optionally with one more parts at the first pressure.

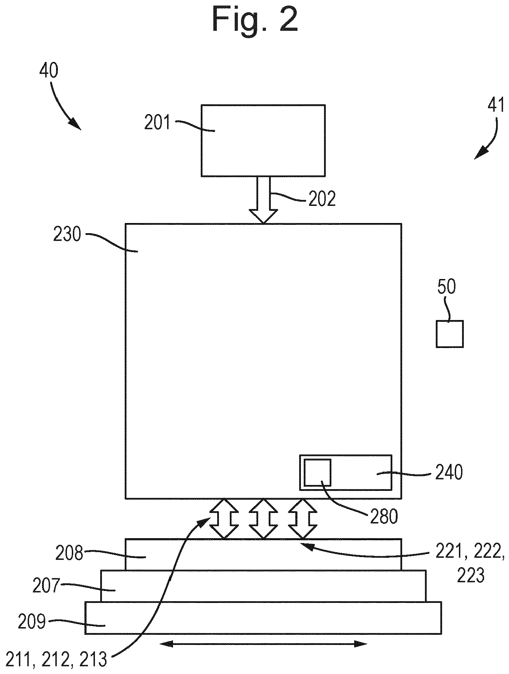

Reference is now made to **FIG. 2**, which is a schematic diagram illustrating an exemplary electron beam system 40, including a multi-beam electron-optical system 41, that is part of the exemplary charged particle beam assessment apparatus 100 of **FIG. 1**. The electron beam system 40 comprises an electron source 201 and a projection apparatus 230. The electron beam system 40 further comprises an actuated stage 209 and a sample holder 207. The electron source 201 and projection apparatus 230 may together be referred to as the electron-optical system 41 or as an electron-optical column. The sample holder 207 is supported by actuated stage 209 so as to hold a sample 208 (e.g., a substrate or a mask) for inspection. The multi-beam electron-optical system 41 further comprises a detector 240 (e.g. an electron detection device). It should be noted that although an electron beam system comprising a multi-beam electron-optical system is described, it is only an embodiment of the invention. The invention disclosed herein may be applied to an electron beam system with a single beamed electron-optical system.

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands for example approximately ten thousand, many tens of thousands or many hundreds of thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209 (e.g. a motorized stage). The controller 50 may perform various image and signal processing functions. The controller 50 may also generate various control signals to govern operations of the charged particle beam inspection apparatus, including the charged particle multi-beam apparatus.

The electron-optical apparatus 230 may be configured to focus sub-beams 211, 212, and 213 onto a sample 208 for inspection and may form probe spots 221, 222, and 223 (for this example three probe spots, one for each sub-beam) on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV are generally treated as secondary electrons, a proportion of the actual backscatter electrons will be counted as secondary electrons.

The detector 240 is configured to detect signal particles such as secondary electrons and/or backscattered electrons and to generate corresponding signals which are sent to a signal processing system 280 for pre-processing, e.g. analog to digital conversion. The detector 240 may be incorporated into the projection apparatus 230. Further details and alternative arrangements of a detector module, sensor and detector array positioned proximate to, up beam, down beam or otherwise integrated into an objective lens can be found in EP Application Number 20216890.2 and PCT Application number PCT/EP2021/068548, which documents are respectively hereby incorporated by reference at least so far as they disclose details of the detector module, sensor and detector array and similar elements.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. The multiple portions may be segments are arranged radially and/or angularly. More specifically, the detector comprising multiple portions may be arranged around a single aperture, which provides an example of such a detector. As mentioned the detection signal from the detector module is used to generate an image. With multiple detecting portions, the detection signal comprises components from the different detecting signals that may be processed as data sets or in a detection image.

The objective lens may an objective lens array and may comprise a plurality of planar electrodes or plates comprising apertures for the respective paths of the beams of the multi-beam. Each plate may extend across the multibeam arrangement. The objective lens may comprise at least two electrodes that may be connected to and controlled respective potentials. There may be additional plates each to control an additional degree of freedom. The detector may be a plate associated with or connected to the objective lens with an aperture for each path of a beam of the multi-beam. The detector may be located above, below or within the objective lens.

A scan deflector may be associated with or even integrated into the objective lens for example as an array of scan deflectors. An array of scan deflectors may be referred to as a deflector array. In an arrangement the scan deflector may be positioned up beam of the object lens. In an arrangement in which the path of the primary beams are collimated up beam of the objective lens, the scan deflectors may be positioned up beam of the objective lens. In an arrangement in which the multibeam is generated from a collimated primary beam from a source by a beam limiting aperture array of or associated with the objective lens, the scan deflector may be a macro scan deflector positioned up beam of the objective lens and so as to operate on the collimated primary beam. Other electron-optical arrangements may be envisaged comprising one or more elements herein described. Such scan deflectors may be controlled by the controller to deflect the beams of the multi-beam along one axis in the plane of the sample or both primary axes over the surface of a sample e.g. in the plane of the sample (which may be orthogonal with respect to each other).

It should be noted that embodiments of scan deflectors that are proximate to the sample, for example integrated or proximate to the objective lens, may have a limited range of scan deflection. However scan deflectors proximate to the sample may be accurately controlled and have a fast response relative to other types of scanning actuators such as an actuated stage.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection, which may be referred to as a type of scanning. The speed of the actuated stage may be referred to as the moving rate. The controller 50 may control movement of the actuated stage 209 so that it changes the speed of the movement of the sample 208 relative to the path of the multi-beam dependent on various parameters. The controller 50 may control deflection of the scan deflectors so that the path of the multibeam moves relative to the stage and thus over the sample surface. The controller 50 may change a beam deflection of the scan deflector and thus the scanning of the beams over the sample surface dependent on various parameters. For example, the controller 50 may control the stage speed (including its direction) and/or scan deflector depending on the characteristics of the inspection scanning elements and steps, for example in the scanning process and/or scans of the scanning process as disclosed in EPA 21171877.0 filed 3 May 2021. The content of such application is hereby incorporated in so far as it discloses a combined stepping and scanning strategy at least of the stage and scanning deflectors. Thus, the moving rate may at different times comprise a stepping frequency and/or a stage scanning rate.

To obtain a two-dimensional image of the sample, the (or each) probe beam is scanned across the surface of the sample in a two-dimensional raster pattern. This involves movement of the beam in two directions: a main scanning direction and a sub-scanning direction which have different orientations, e.g. are orthogonal. The main scanning direction may be referred to as the fast scan direction. For example the scan deflector may be controlled to actuate the primary beam (e.g. multi-beam) in the fast direction. The sub-scanning direction may be referred to as the slow scan direction. For example the stage may be controlled to actuate the sample relative to the path of the primary beam; the scan deflector may be controlled to actuate the path of the beam over the sample surface in the slow direction; or both the stage and the scan deflector are actuated to achieve scanning in the slow direction. The stage is preferred to be used only in the slow direction because its inertia due to its large mass makes achieving the movement of scanning in the fast direction, e.g. acceleration, more challenging than alternatives such as a scan deflector.

Known multi-beam systems, such as the electron beam system 40 and charged particle beam assessment apparatus 100 described above, are disclosed in US2020/118784, US202002/03116, US2019/0259564 and WO2021078352 which are hereby incorporated by reference.

The electron beam system 40 may comprise a projection assembly to regulate accumulated charges on the sample by illuminating the sample 208.

Images output from a charged particle assessment device, e.g. electron beam system 40, are desirably processed by a data processing device automatically to detect defects in samples being assessed. The data processing device, or at least a part of the data processing device, may be part of controller 50, part of another computer in the fab or integrated elsewhere in the charged particle assessment device. Since a charged particle assessment device, especially one using multiple charged particle beams, may generate very large amounts of data representing images of samples, it is desirable to perform some initial data processing, e.g. an initial identification of candidate defects, within the charged particle assessment device. If this is done, only data relating to the candidate defects, e.g. image clips, need to be transmitted out of the charged particle assessment device for further analysis. Therefore the amount of data that must be output from the charged particle assessment device is greatly reduced and data transmission rates do not limit throughput of the charged particle assessment device.

Various approaches may be taken to detect defects in images generated by a charged particle assessment device. A common approach is to compare an image of a part of the sample, referred to herein as a sample image, to one or more reference images. In practice, data points of a datastream representing the sample image are compared to data points of the reference image retrieved from a memory or delivered in a parallel datastream. For the sake of brevity, this process may be referred to below as comparing images; the data points may be referred to as pixels.

The result of the comparison of a sample image to a reference image may be a simple binary value representing a difference or a correspondence (i.e. matching) between the sample and references images. Desirably, the result of the comparison is a difference value representing the magnitude of the difference between the sample image and the reference image. More desirably, the result of the comparison is a difference value for each pixel (or each group of adjacent pixels which may be referred to a 'region of pixels') so that locations of defects within a source image can be determined with greater precision.

To determine if a difference of a pixel or a region of pixels between source image and reference image represents a candidate defect in the pattern being inspected, a threshold may be applied to the difference value corresponding to the pixel or region of pixels. The threshold may be fixed in advance, e.g. for a specific charged particle beam system or for a specific pattern to be inspected. The threshold may be a user-set parameter or by other conditions, for example it is updated from time to time dependent on application or from assessment. The threshold may be determined dynamically, updated during the course of processing, or both. Alternatively, a predetermined number of locations having the highest difference values may be selected as candidate defects for further inspection. Adjacent pixels having difference values higher than a threshold may be considered a single defect or candidate defect. All pixels of a single defect may be ascribed the same difference value. Such adjacent pixels and all pixels of a single defect may be referred to as a region of pixels.

False positives, i.e. samples labelled as having candidate defects when in fact no significant defect is present, can occur, e.g. due to noise. The rate of false positives can be affected by appropriate choice of the threshold for determining the presence of a defect. The rate of false positives is further controlled by applying noise reduction to either or both of the reference image and the sample image. However, noise reduction increases the amount of processing required to detect defects.

If it is desired to reduce noise in the sample image (or reduce the effect of noise in the image) filtering may be applied such as by averaging out the noise. An efficient and effective approach which may be used is by applying a simple filter by convolution, e.g. a uniform filter (convolution with a uniform kernel). The efficiency and effectiveness of noise reduction in the sample image may be optimized by suitable selection of the size of the (uniform) filter. The optimum size of the filter may depend on factors such as the size of features on the sample, the size of defect to be detected, the resolution of the charged particle assessment device, the amount of noise in the images and the desired compromise between sensitivity and selectivity. The size of the kernel used to implement the filter may be equal to a non-integer number of pixels. A width in the range of 1.1 to 5 pixels, desirably in the range of 1.4 to 3.8 pixels, for the kernel is suitable in a variety of use cases. Further details of filtering of sample image data are given in International Application PCT/EP2022/060622 filed 21 April 2022, which document is hereby incorporated by reference at least in relation to the description of filters and filtering to reduce noise. Such filtering may be complementary or an alternative to the invention disclosed herein. Better filtering enables more noise in the raw images to be tolerated, so that filtering is an alternative to the disclosed invention to increase throughput at a lower signal to noise ratio (SNR). However, filtering and the disclosed invention can be considered to be complementary because they both may be applied in the same assessment process. Simultaneous application of filtering and the disclosed invention may combine to drive down the SNR enabling a larger throughput.

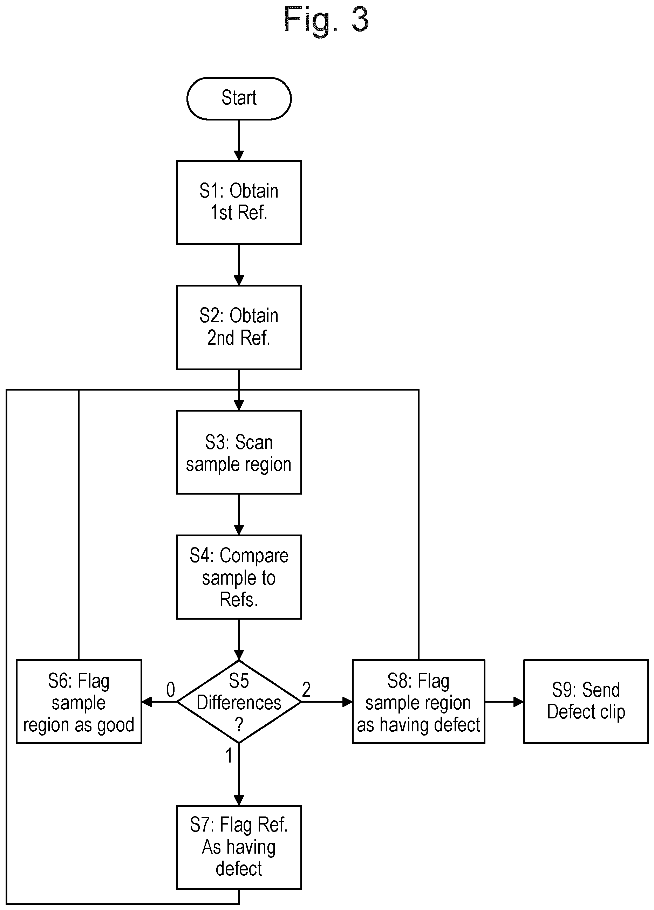

A method of assessing samples according to an embodiment is depicted in **FIG. 3****.** In this method, the sample image is compared to two reference images obtained from different parts of the same sample as the sample image. (Note a sample image may be referred to as a 'test image'.) The method begins with obtaining S1 a first reference image and obtaining S2 a second reference image. Details of obtaining the reference images are described below. In a multi-beam or multi-column charged particle assessment device, the two reference images may be obtained in parallel, for example in a single scan of the multibeam over the same surface. The two reference images may be scanned by two different beams of the plurality of beams. At least the two reference images cover a surface area of the sample that is within the area of the field of view of the multibeam at the sample surface. In a different embodiment, the two reference images are scanned in two separate scans or reference scans; it is noted when using a single-beam charged particle assessment device, separate scans scan the two references regions. A sample region (which may also be referred to as a test region) is scanned S3 to obtain a sample image.

The sample region is compared S4 to the two reference images. The comparison may be performed on a pixel-by-pixel basis or by groups of pixels. An alignment process may be performed before the comparison. At S5 a decision is made as a result of which flow proceeds to step S6, S7 or S8. The decision at S5 is as to whether the comparison reveals: A) no differences between the sample image and the reference images (0 differences) in which case flow transfers to S6; B) a difference between the sample image and one of the reference images (one (1) difference) in which case flow transfers to S7; and C) differences between the sample image and both reference images (two (2) differences) in which case flow transfers to S8. The sample and reference images are desirably multivalued so that a difference is recognized if the difference between pixel values is greater than a threshold. If the comparison is performed on the basis of a group of pixels a threshold may be applied to the number of pixels in the group that are different.

Where there are no differences between the sample image and the reference images, the sample image is considered to be defect free and the sample region may be flagged S6 as defect free. A new sample region is scanned and the process repeats until all regions to be assessed have been processed.

Where there is a difference between the sample image and one of the reference images, it is assumed that the one of the reference images has an apparent defect, e.g. due to noise and the reference region is flagged accordingly S7. The process continues with a new sample region being scanned.

Where there are differences between the sample image and both reference images at the same location in the pattern, it is assumed that the sample image represents a candidate defect on the sample and the sample region is flagged S8 accordingly. Data, such as a data set, representing the candidate defect, e.g. an image clip, may be transmitted S9 to an external apparatus for further analysis. The process continues with a new sample region being scanned.

The two reference images are obtained with higher fidelity than the sample image whereas in prior methods the reference images and sample images are obtained under the same conditions. Here fidelity of an image can indicate the degree to which the image shows the true character of the corresponding region of the sample. In other words, the reference images are a more accurate representation of the corresponding region of the sample. Desirably, the reference images have a higher signal to noise ratio than the sample images. Desirably, the reference images have a lower levels of distortion than the sample images. Desirably, the reference images have a higher contrast to noise ratio (as described further below) than the sample images. Desirably, the reference images have fewer nuisance defects (that is defects that appear to be present in the image but do not represent an actual defect on the sample). In general, the reference images may be improved in any characteristic that reduces false positives and/or false negatives when sample images are compared to the reference images.

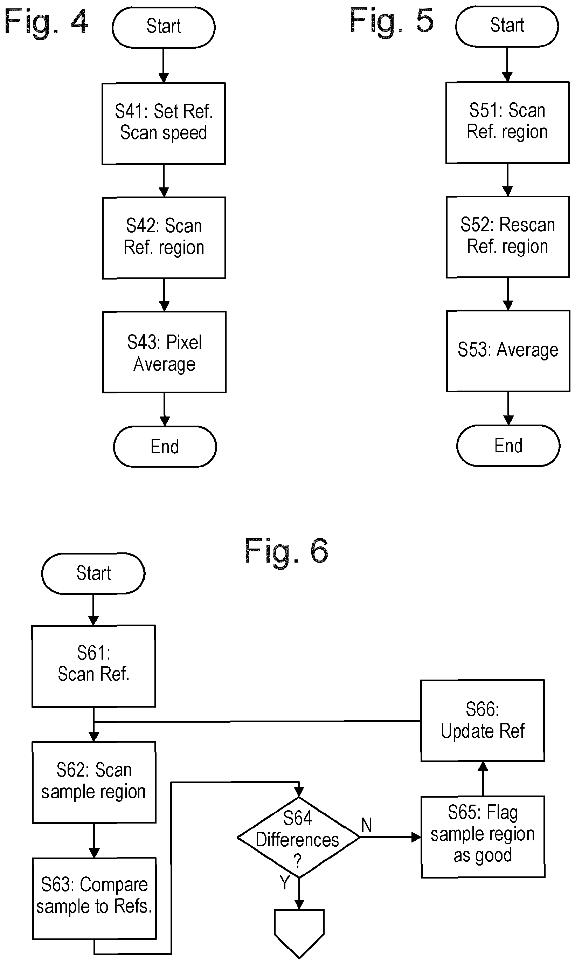

Several different approaches may be used to obtain the reference image with higher fidelity than the sample image. For example the reference image may be obtained by scanning a part of the sample designated as a reference region at a slower rate than is used to obtain the sample images, as described below with reference to **FIG. 4****.** The reference image may be obtained by scanning a part of the sample designated as a reference multiple times and combining the results of the multiple scans, as described below with reference to **FIG. 5****.** Another approach is to improve the fidelity of the reference image during the assessment process by averaging the reference image with newly obtained sample images, as described below with reference to **FIG. 6****.** These different approaches may be used separately or in a combination of one more different approaches, so long as combined approaches are compatible with each other. It should be noted that whatever the definition of fidelity, by comparing the sample image to the reference images and noting that definition of fidelity applies to all three images, the comparison shows the differences between each reference image and the sample image; that is irrespective of the fidelity of either or both of the images.

Optionally, the same beam (of the same column in the case of a multi-column system) is used to generate the sample image and the two reference images. This has the advantage that column to column and beam to beam corrections are not required and the routing of data can be simplified. For example the calibration of the relative position of a beam relative to the ideal beam position can be avoided.

Embodiments of the present invention enable the throughput of a charged particle assessment apparatus to be increased, whilst maintaining a desired capture/nuisance ratio. A user of a charged particle assessment apparatus may desire to detect at least a certain proportion (e.g. 90%) of the true defects on a sample (referred to as the capture rate) but at the same time having no more than a certain proportion (e.g. 10%) of the detected candidate defects being false positives (nuisance rate). A trade-off between the capture rate and the nuisance rate can be made by varying the threshold difference between the sample image and the reference images to detect a candidate defect. Increasing the threshold desirably lowers the nuisance rate but undesirably reduces the capture rate and vice versa.

Reducing noise in the reference and sample images reduces the nuisance rate without reducing the capture rate. However, reducing noise (beyond what can be achieved through signal processing) generally reduces throughput, for example because the scan speed must be reduced. It has generally been assumed that the reference images must be obtained under the same conditions as are used to obtain the sample images in order to enable a valid comparison, i.e. to compare like with like. However the present inventors have determined that by investing time in improving the fidelity of the reference images (e.g. by using a slower scan speed or performing multiple scans) it is possible to save time in scanning the sample images (e.g. by scanning at a faster rate than otherwise) without detriment to the capture and nuisance rates and therefore increase throughput. The amount of throughput that can be gained depends on the number of reference and sample images that are used; the more sample images, the larger the throughput gain. Alternatively, the throughput can be maintained (compared to scanning the reference and sample images under the same conditions) and capture and nuisance rates improved.

As mentioned above, a first approach to improving the fidelity of the reference images is to scan at a slower rate than is used to scan the sample images. This is depicted in **FIG. 4****.** In step S41 a reference scanning rate is set. The reference scanning rate may be an integer sub-multiple of the sample scanning rate (in other words the sample scanning rate is n times the reference scanning rate where n is a positive integer, e.g. 2 or 3). In step S42 the reference regions are scanned at the reference scanning rate to generate high resolution reference images. In step S43 the high resolution reference images are down-sampled to the same resolution as the sample images. In the case of the reference scanning rate being an integer sub-multiple of the sample scanning speed, down-sampling can be performed by simply averaging n adjacent pixels. If the reference scanning rate is not an integer sub-multiple of the sample scanning speed, interpolation may also be performed. A simple averaging requires less processing so that it is advantageous that reference scanning rate is an integer sub-multiple of the sample scanning speed. Down-sampling increases the signal to noise ratio (SNR) and/or the contrast to noise ratio (CNR). This enables the reference images to have a higher fidelity than if they were obtained at the scanning rate of the sample image. Scanning the reference images at a slower speed for an improved fidelity can enable the sample images to be scanned at a scanning rate faster than if the reference images and the sample images were scanned at the same scanning rate whilst still achieving the same defect detection performance. This provides a throughput benefit in most cases, but the size of the benefit will depend on the number of sample images that are scanned, the different scanning rates, and other factors such as routing between the reference and sample regions. Since an embodiment can be implemented only by a software upgrade, even a small benefit (e.g. throughput improvement) would be cost effective and simple to implement.

Take for example the use case in which the sample scanning rate is increased and the reference scanning rate is decreased relative to known techniques in which the sample and reference images are scanned at the scanning rate. (For a specific example, the factor in the reduction of the same scanning rate of the reference image is the same as the factor of the increase in the scanning rate of the sample; but in most cases this relationship would not apply.) The net time taken to scan the two reference images using the invention is generally longer than the time to scan the two reference images using known techniques. However with increasing number of sample images scanned, the required time to scan the two reference images and all the sample images is shorter than scanning the two reference images and all the sample images as in previously known techniques. The scanning rate of the reference image relative to the scanning rate of the sample images may depend on the number of sample images scanned (or to be acquired).

In the method of **FIG. 4** it is assumed that the detector sampling rate is kept constant so that reducing the scanning rate leads to a higher resolution image. It is also possible to reduce the detector sampling rate, desirably in the same proportion as the scanning rate. In this case, the image resolution is unchanged and the pixel averaging step S43 can be omitted. In effect pixel averaging is performed in the detector. It is possible to obtain the two reference images at different scanning rates and/or different sampling rates provided that the reference images are processed to images of the same resolution as the sample images to which they will be compared.

A second approach to improving the fidelity of the reference images is to scan the reference region multiple times, e.g. two or three times. This is depicted in **FIG. 5****.** In step S51, a reference region is scanned. In step S52 the reference region is scanned again so that multiple overlapping images of the reference region are obtained. In step S53 the multiple overlapping images are averaged. An alignment process may be performed before the multiple overlapping images are averaged. This process is repeated for another reference region. Depending on the position of the reference region it may be more efficient to obtain a first image of each reference region and then a second image of each reference region rather than obtaining two images of one reference region then two images of the second reference region. Obtaining multiple images of each reference region and then combining them (e.g. by averaging) increases the signal to noise ratio (SNR) and/or the contrast to noise ratio (CNR) hence improving fidelity. Thus increasing the number of images used of each reference region to generate the reference image increases the fidelity of the reference image. Again, this provides a throughput benefit in most cases, but the size of the benefit will depend on the number of sample images that are scanned, the number of times each of the reference regions is scanned, the different scanning rates, and other factors such as routing between the reference and sample regions.

It will be appreciated that the first and second approaches may be combined, i.e. multiple images of the reference regions are obtained at a slower scanning speed than is used for the sample images. However, the improvement in the reference images may be subject to diminishing returns.

A third approach to improving the fidelity of the reference images is to update the reference image(s) during the assessment of sample regions. This is depicted in **FIG. 6****.** A reference region is scanned S61 to generate a reference image and a sample region is scanned S62 to generate a sample image. These steps may be performed in either order or simultaneously if a multi-beam assessment apparatus is used. The sample image is compared S63 to the reference image and it is determined S64 whether there are differences (e.g. applying a threshold as described above). An alignment process may be performed before the comparison. In the event that significant differences indicative of a candidate defect exist, the sample region may be flagged and data (e.g. a clip) sent for further analysis as described above with reference to steps S8 and S9 of **FIG. 3****.** If no significant differences exist, the sample region is flagged S65 as defect free and the reference image is updated S66. The process repeats with the scanning of a new sample region as a new iteration. It should be noted that this approach appears to use a single reference. A single reference may suffice after inspecting multiple sample images because the reference image is the average of multiple sample images; differences due to for example false positives are statistically reduced (e.g. averaged out). However, initially two reference images may be used to mitigate the risk of a false positive being present in the reference image. Multiple different reference images may be used until a contribution of difference such as a false positive from a reference image is statistically reduced to have little or even no meaningful statistical contribution to the reference image.

Updating the reference image may comprise generating a combination (for example average) of the previous reference image with the current sample image. The average may be a weighted average. The weight given to the sample image may vary between iterations, e.g. decreasing. For example, when the reference image is updated for the nth time, the weight of the sample image may be proportional to 1/n. Updating of the reference image need not be carried out every time a new sample image is found to be defect free. Updating the reference image increases the signal to noise ratio (SNR) and/or the contrast to noise ratio (CNR). Thus each update of the reference image improves the fidelity of the reference image for comparing with later obtained sampled images.

The concept of improving fidelity by updating the reference image as new sample images are obtained can also be applied starting with just one reference image. Desirably the initial reference image is obtained with a higher fidelity than the sample image. Desirably a plurality of sample images are obtained from different regions of the sample.

Comparing each sample image to the reference image can generate a data set indicative of candidate defects present in the sample image. The fidelity of the reference image can be further improved by verifying the candidate defects in the datasets by removing candidate defects present in a selection, desirably all, of the datasets, desirably the verifying comprising comparing the selection of data sets and/or generating a removal set of defects of the possible defects present in all of the selected data sets. For example, if a candidate defect is identified at the same location in many sample images, it may be more likely that the reference image has a defect at that location. In that case, the reference image can be improved by updating the reference image as an updated reference (or new reference image) by removing the candidate defects from the reference image that are present in the removal set of defects. Then the method can continue by obtaining a further sample image of a sample region of the sample and comparing the further sample image with the updated reference to identify any candidate defects in the sample region. Desirably, the data sets of candidate defects can be used to remove false positives from the reference image for assessing further sample images of the sample.

Other approaches to improving the fidelity of the reference images may also be employed, for example by increasing the beam current, e.g. the reference images are scanned using a reference beam current that is higher than a sample beam current used to scan sample images. Whilst increasing the beam current generally improves the quality of images it is not a linear relationship due to surface charging effects and stochastic effects. In an embodiment, the beam current is related to the intended resolution. For example high current beams may be used for large resolution. Low current beams may be used for small resolution. Noise may have a more significant impact when using low beam currents than high beam currents. In the present approach using higher beam current for scanning a reference image than when scanning sample images, may have the reference image and the sample images scanned at a similar or even the same resolution. The impact of the noise on the refence sample image scanned at larger beam current may consequently be less than the sample images scanned at a lower beam current.

Embodiments of the present invention are especially useful where the pattern formed in each die of the sample does not have significant repeating elements and/or the region of the pattern to be inspected does not have repeating elements. Such samples may be referred to as having a "random" pattern though of course the pattern is designed and not random. The pattern does however repeat from die to die, in other words all dies on the sample are notionally identical. The invention is not limiting as to which dies of a sample are chosen to be scanned as reference regions and which are to be scanned as sample regions. However, there may be an advantage in selecting from reference regions areas of the sample that have historically lower defect rates. For example it may be desirable to select non-edge dies as reference regions.

Although the described invention is with reference to a charged particle electron-optical system configured to project a multi-beam towards a sample. The invention is equally applicable to a charged particle system configured to project a single beam of charged particles towards a sample. The inventors have demonstrated that the effective improvement of the invention for a multibeam and single beam system is proportionately the same. However, the area processed using a multibeam system is likely to be larger because the area of each region scanned by a multibeam system is generally larger than that of a single beam system. A multibeam system may be used to achieve a net higher throughput than a single beam system. The size of the throughput benefit will depend on the number of sample images that are scanned, the number of times each of the reference regions is scanned, the different scanning rates, and other factors such as routing between the reference and sample regions.

Note there is an exception when a multibeam system can secure an improvement over the improvement achieved by implementing the invention in a single beam system. That is when scanning two reference regions, the reference regions are scanned in a single scan of the multibeam. In such a case the time required for the slower reference scan is halved by acquiring the reference images in a single scan instead of two scans. It is noted that in general there is a discernable increase in throughput which is more significant when scanning a small number of sample regions, for example less than ten.

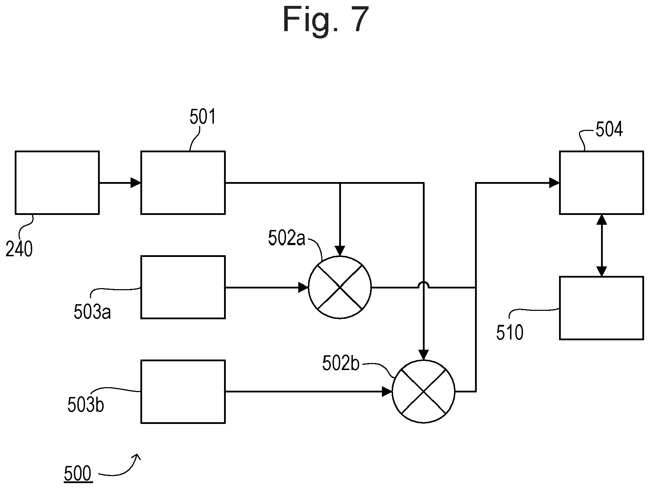

As depicted in **FIG. 7****,** data processing device 500 which can be used to analyze sample images comprises a filter module 501 which receives and filters a sample image from a detector module 240, reference image storage units 503a, 503b which supply reference images based on source images, comparators 502a, 502b which compare the filtered sample image to the reference images and an output module 504 which processes and outputs the result of the comparison. Alignment of the sample images and reference images may be performed, either as a separate step before or after the filtering step or as a part of the comparison step.

Filter module 501 applies a filter to the input data, as described above. Filter module 501 is conveniently implemented by dedicated hardware, e.g. an FPGA or an ASIC. Such dedicated hardware can be more efficient and economic than programmed general purpose computing devices such as a standard or common type of CPU architecture. The processor may be less powerful than a CPU, but may have architecture suited to processing software for processing the detection signal data, i.e. the images and so be capable of processing the images in the same or less time than the CPU. Such detected processing architecture, despite having a processing capability lower than most contemporaneous CPUs may be as fast at processing the data because the more efficient data architecture of the dedicated processing architecture. A general purpose CPU may be advantageous in that it allows the filter to be changed easily.

With reference again to **FIG. 7****,** comparators 502a, 502b may be any logic circuit capable of comparing two values, for example an XOR gate or a subtractor. Comparators 502a, 502b are also suitable for implementation by dedicated hardware, e.g. an FPGA or an ASIC. Such dedicated hardware can be more efficient and economic than programmed general purpose computing devices, e.g. CPUs. Desirably, comparators 502a, 502b are implemented on the same dedicated hardware as filter module 501.

In some cases, the reference image stores 503a, 503b can also be implemented in dedicated hardware. In that case it is desirable that the reference image generator is implemented in the same dedicated hardware as the comparator and/or filter module.

Output module 504 receives the results output by comparator 502 and prepares output to the user, other fab systems or for further processing within the inspection system. The output may be in any of several different forms. In a simplest option, the output may simply be an indication that the sample has or does not have a defect. However, since almost all samples will have at least one potential defect more detailed information is desirable, for example as a data set, such as an image (e.g. such as a data set renderable as an image). Therefore the output may comprise, for example, a map of defect locations, a deviation image, a clip of pixel data (for example of the image and the reference image or of the reference image), and/or information as to the severity of a possible defect represented by the magnitude of the difference between the sample image and the reference image, for example how the sample image deviates from the reference image.

Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information may be used, e.g. a list, data set, image or a map. Desirably, output module 504 may output clips, that is images of regions of the sample where potential defects have been detected. This allows the potential defect to be further examined to determine if the defect is real and serious enough to affect operation of the device formed on or present in the sample. The rest of the source image, i.e. those parts not saved as clips, may be discarded to save on data storage and transfer requirements. The data set may thus be a set of clips; the image may comprise the set of clips.

Data processing device 500 may be remote from a detector array, for example within a vacuum chamber. The data processing device may be part of an electron-optical assembly of the electron-optical column; such assembly may comprise the detector (such as detector array), and an objective lens (such as an objective lens array). The detector may be in a path of the beam grid and the data processing device may be away from the path of the beam grid. The data processing device may be separate from detector, but electrically connected to the detector. In a different embodiment at least part of, if not all of, the data processing device is remote from the electron optical column, such as remote from the electron-optical assembly, even external to a vacuum chamber comprising the electron-optical column. At least part of the data processing device may be in signal communication with the detector through a feedthrough in a wall of the chamber.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

Although the embodiment described herein is a multi-beam electron-optical system featuring electrostatic electron optics, for example featuring electrode plates with apertures to operate on the different beams on the multi-beam, the assessment system may feature a multibeam electron-optical system comprising magnetic components. For example the electron-optical system may comprise at least one of: a macro magnetic condenser lens which may be set to a non-rotational setting; a stack of electron-optical arrays for fine operation on the beams of the multibeam; a beam limiting aperture array for generating and/or shaping the plurality of beams of the multibeam, which may be a plate up beam of the condenser lens and/or a plate down beam between the condenser lens and the stack of electron optical arrays; a macro magnetic objective lens for projecting the plurality of beams onto a sample and which may feature electrostatic elements; a Wien filter for permitting the primary beams towards the sample and for directing signal particles from the sample towards a detector which may be in a secondary column; and a detector in the secondary column. In another arrangement of an assessment system, the electron-optical system may be designed to project a single beam towards the sample. Such a single beam design may be similar to the multibeam beam electron-optical system featuring a magnetic condenser lens; in a variation the detector is in the main column (i.e. is there is not secondary column or Wien filter) for example facing a sample position and/or between the condenser lens and the objective lens.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array and objective lens array, under the control of the controller or control system or control unit. An actuatable component, such as a stage, may be controllable to actuate and thus move relative to another components such as the beam path using one or more controllers, control systems, or control units to control the actuation of the component.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Functionality provided by the computers and processors such as the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. Such computer programs may take the form of multiple computer programs that may be distributed for example implemented by different processors. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The term "image" used herein is intended to refer to any data structure of values wherein each value relates to a sample of a location and the arrangement of values in the array corresponds to a spatial arrangement of the sampled locations. The term "data map" may be used to describe such a data structure. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location. An image may be stored in any convenient format in a computer-readable storage medium.

Embodiments of the invention are described in the following numbered clauses.

Clause 1. A charged particle assessment method for identifying candidate defects in samples by scanning a charged particle beam across a sample; the method comprising:
obtaining a first reference image from a first region of the sample and a second reference image from a second region of the sample using a charged particle assessment apparatus;
obtaining a sample image from a third region of the sample using the charged particle assessment apparatus; and
comparing the sample image to the first reference image and to the second reference image to identify any candidate defects in the third region;
wherein the first reference image and/or the second reference image are obtained with a higher fidelity than the sample image.

Clause 2. A charged particle assessment method according to clause 1 wherein:
obtaining the first reference image and the second reference image comprises relatively scanning the sample and the charged particle beam at a reference scanning rate;
obtaining the sample image comprises relatively scanning the sample and the charged particle beam at a sample scanning rate; and
the reference scanning rate is slower than the sample scanning rate such that the reference image has a higher fidelity than the sample image.

Clause 3. A charged particle assessment method according to clause 2 wherein obtaining the first reference image and the second reference image comprises generating a first high resolution reference image and/or a second high resolution reference image at the reference scanning rate and downsampling the first high resolution reference image and/or the second high resolution reference image to generate the first reference image and/or the second reference image respectively having a resolution equivalent to the sample image.

Clause 4. A charged particle assessment method according to clause 2 or 3 wherein the sample scanning rate is an integer multiple of the reference scanning rate.

Clause 5. A charged particle assessment method according to clause 4 wherein down-sampling comprises averaging pixel values of the first high resolution reference image and/or averaging pixel values of the second high resolution reference image.

Clause 6. A charged particle assessment method according to clause 2 or 3 wherein the sample scanning rate is a non-integer multiple of the reference scanning rate.

Clause 7. A charged particle assessment method according to clause 6 wherein down-sampling comprises interpolating pixel values of the first high resolution reference image and/or the second high resolution reference image.

Clause 8. A charged particle assessment method according to any one of clauses 2 to 7 wherein relatively scanning the sample and the charged particle beam comprises moving the sample using an actuated stage at a moving rate and scanning the charged particle beam using a scan deflector at a scan deflector rate and, when obtaining the reference image, at least one of the moving rate and the scan deflector rate is higher than when obtaining the sample image, desirably the moving rate comprises a stepping frequency and/or stage scanning rate.

Clause 9. A charged particle assessment method according to any one of the preceding clauses wherein:
obtaining the first reference image and the second reference image comprises obtaining multiple overlapping images of the first region and the second region and averaging the multiple overlapping images to obtain the first reference image and the second reference image respectively that have a higher fidelity than the sample image.

Clause 10. A charged particle assessment method according to any one of the preceding clauses wherein:
the first reference image and the second reference image are obtained using a reference beam current; and
the sample image is obtained using a sample beam current;
wherein the reference beam current is higher than the sample beam current.

Clause 11. A charged particle assessment method according to any one of the preceding clauses further comprising:
generating a new reference image by combining the sample image and one of the first reference image and the second reference image;
obtaining a further sample image from a further region of the sample using the charged particle assessment apparatus; and
comparing the further sample image to the new reference image to identify any candidate defects in the further region.

Clause 12. A charged particle assessment method according to clause 11 wherein generating a new reference image comprises calculating an average, desirably a weighted average, of the sample image and one of the first reference image and the second reference image.

Clause 13. A charged particle assessment method according to clause 11 or 12 further comprising repeating the steps of generating a new reference image; obtaining a further sample image and comparing the further sample image.

Clause 14. A charged particle assessment method according to any one of the preceding clauses wherein the first reference image and the second reference image have a reference signal to noise ratio and the sample image has a sample signal to noise ratio, wherein the reference signal to noise ratio is higher than the sample signal to noise ratio.

Clause 15. A charged particle assessment method for identifying candidate defects in samples by scanning a charged particle beam across a sample; the method comprising:
obtaining a reference image from a first region (desirably a reference region) of a sample using a charged particle assessment apparatus;
obtaining a sample image from a second region (desirably a sample region) of the sample using the charged particle assessment apparatus;
comparing the sample image to the reference image to determine if there might be a defect in the sample region;
generating a new reference image by combining the sample image and the reference image;
obtaining a further sample image from a further region of the sample using the charged particle assessment apparatus; and
comparing the further sample image to the new reference image to determine if there might be a defect in the further region.

Clause 16. A charged particle assessment method for detecting defects in samples by scanning a charged particle beam across a sample; the method comprising:
obtaining a reference image from a first region of a sample using a charged particle assessment apparatus;
obtaining a sample image from a second region of the sample using the charged particle assessment apparatus;
comparing the sample image to the reference image to identify any candidate defects in the sample region;
wherein the reference image is obtained with a higher fidelity than the sample image.

Clause 17. The particle assessment method of clause 16, further comprising obtaining a plurality of sample images from different regions of the sample.

Clause 18. The particle assessment method of clause 17, wherein the comparing each sample image to the reference image comprises generating a data set indicative of candidate defects present in the sample image.

Clause 19. The particle assessment method of clause 18, further comprising verifying the candidate defects in the datasets by removing candidate defects present in a selection, desirably all, of the datasets, desirably the verifying comprising comparing the selection of data sets and/or generating a removal set of defects of the possible defects present in all of the selected data sets.

Clause 20. The particle assessment method of clause 19, further comprising updating the reference image as an updated reference (or new reference image) by removing the candidate defects from the reference image that are present in the removal set of defects.

Clause 21. The particle assessment method of clause 20, further comprising obtaining a further sample image of a sample region of the sample and comparing the further sample image with the updated reference to identify any candidate defects in the sample region.

Clause 22. The particle assessment method of any of clauses 18 to 21 comprising using the data sets of candidate defects to remove false positives from the reference image for assessing further sample images of the sample.

Clause 23. A computer program for controlling a charged particle assessment apparatus, the computer program comprising instructions that, when executed by the charged particle assessment apparatus, cause the charged particle assessment apparatus to perform a method according to any one of the preceding clauses.

Clause 24. A charged particle assessment apparatus for identifying candidate defects in a sample by scanning a charged particle beam across the sample; the apparatus comprising:
a detector unit configured to output a digital detection signal of pixel values in response to signal particles incident from the sample;
a scanning unit for relatively scanning the sample and the charged particle beam;
a controller configured to control the detector unit and the scanning unit to obtain a first reference image from a first region of a sample and a second reference image from a second region of the sample and to obtain a sample image from a third region of the sample; and
a comparator configured to compare the sample image to the first reference image and to the second reference image to identify any candidate defects in the third region;
wherein the first reference image and/or the second reference image are obtained with a higher fidelity than the sample image.

Clause 25. A charged particle assessment apparatus according to clause 24 wherein the scanning unit comprises:
a charged particle device configured to direct a charged particle beam toward the sample; and
a stage configured to support the sample, the charged particle device and the stage being configured to scan a surface of the sample with the charged particle beam.

Clause 26. A charged particle assessment apparatus according to clause 24 or 25 wherein the controller is configured to control the detector unit and the scanning unit to:
obtaining the first reference image and the second reference image by relatively scanning the sample and the charged particle beam at a reference scanning rate;
obtaining the sample image by relatively scanning the sample and the charged particle beam at a sample scanning rate; and
the reference scanning rate is slower than the sample scanning rate such that the reference image has a higher fidelity than the sample image.

Clause 27. A charged particle assessment apparatus according to clause 26 wherein the controller is configured to control the detector unit and the scanning unit to:
obtain the first reference image and the second reference image by generating a first high resolution reference image and/or a second high resolution reference image at the reference scanning rate and downsampling the first high resolution reference image and/or the second high resolution reference image to generate the first reference image and/or the second reference image respectively having a resolution equivalent to the sample image.

Clause 28. A charged particle assessment apparatus according to clause 26 or 27 wherein the sample scanning rate is an integer multiple of the reference scanning rate.

Clause 29. A charged particle assessment apparatus according to clause 28 wherein down-sampling comprises averaging pixel values of the first high resolution reference image and/or averaging pixel values of the second high resolution reference image.

Clause 30. A charged particle assessment apparatus according to clause 26 or 27 wherein the sample scanning rate is a non-integer multiple of the reference scanning rate.

Clause 31. A charged particle assessment apparatus according to clause 30 wherein down-sampling comprises interpolating pixel values of the first high resolution reference image and/or the second high resolution reference image.

Clause 32. A charged particle assessment apparatus according to any one of clauses 25 to 31 wherein the controller is configured to control the detector unit and the scanning unit to:
obtain the first reference image and the second reference image by obtaining multiple overlapping images of the first region and the second region and averaging the multiple overlapping images to obtain the first reference image and the second reference image respectively that have a higher fidelity than the sample image.

Clause 33. A charged particle assessment apparatus according to any one of clauses 25 to 32 wherein the controller is configured to control the detector unit and the scanning unit to:
obtain the first reference image and the second reference image using a reference beam current; and
obtain the sample image using a sample beam current;
wherein the reference beam current is higher than the sample beam current.

Clause 34. A charged particle assessment apparatus according to any one of clauses 25 to 33 wherein the controller is further configured to control the detector unit and the scanning unit to:
generate a new reference image by combining the sample image and one of the first reference image and the second reference image;
obtain a further sample image from a further region of the sample; and
compare the further sample image to the new reference image to identify any candidate defects in the further region.

Clause 35. A charged particle assessment apparatus according to clause 34 wherein the controller is configured to control the detector unit and the scanning unit to generate a new reference image by calculating an average, desirably a weighted average, of the sample image and one of the first reference image and the second reference image.

Clause 36. A charged particle assessment apparatus according to clause 34 or 35 wherein the controller is further configured to control the detector unit and the scanning unit to repeat the steps of generating a new reference image; obtaining a further sample image and comparing the further sample image.

Clause 37. A charged particle assessment apparatus according to any one of clauses 25 to 36 wherein the first reference image and the second reference image have a reference signal to noise ratio and the sample image has a sample signal to noise ratio, wherein the reference signal to noise ratio is higher than the sample signal to noise ratio.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged particle assessment method for identifying candidate defects in samples by scanning a charged particle beam across a sample; the method comprising:
obtaining a first reference image from a first region of the sample and a second reference image from a second region of the sample using a charged particle assessment apparatus;
obtaining a sample image from a third region of the sample using the charged particle assessment apparatus; and
comparing the sample image to the first reference image and to the second reference image to identify any candidate defects in the third region;
wherein the first reference image and/or the second reference image are obtained with a higher fidelity than the sample image.

2. A charged particle assessment method according to claim 1 wherein:
obtaining the first reference image and the second reference image comprises relatively scanning the sample and the charged particle beam at a reference scanning rate;
obtaining the sample image comprises relatively scanning the sample and the charged particle beam at a sample scanning rate; and
the reference scanning rate is slower than the sample scanning rate such that the reference image has a higher fidelity than the sample image.

3. A charged particle assessment method according to claim 2 wherein obtaining the first reference image and the second reference image comprises generating a first high resolution reference image and/or a second high resolution reference image at the reference scanning rate and downsampling the first high resolution reference image and/or the second high resolution reference image to generate the first reference image and/or the second reference image respectively having a resolution equivalent to the sample image.

4. A charged particle assessment method according to claim 2 or 3 wherein the sample scanning rate is an integer multiple of the reference scanning rate or wherein the sample scanning rate is a non-integer multiple of the reference scanning rate

5. A charged particle assessment method according to claim 4 wherein down-sampling comprises averaging pixel values of the first high resolution reference image and/or averaging pixel values of the second high resolution reference image.

6. A charged particle assessment method according to claim 4 wherein down-sampling comprises interpolating pixel values of the first high resolution reference image and/or the second high resolution reference image.

7. A charged particle assessment method according to any of claims 2 to 6 wherein relatively scanning the sample and the charged particle beam comprises moving the sample using an actuated stage at a moving rate and scanning the charged particle beam using a scan deflector at a scan deflector rate and, when obtaining the reference image, at least one of the moving rate and the scan deflector rate is higher than when obtaining the sample image, desirably the moving rate comprises a stepping frequency and/or stage scanning rate.

8. A charged particle assessment method according to any of the preceding claims wherein:
obtaining the first reference image and the second reference image comprises obtaining multiple overlapping images of the first region and the second region and averaging the multiple overlapping images to obtain the first reference image and the second reference image respectively that have a higher fidelity than the sample image.

9. A charged particle assessment method according to any of the preceding claims wherein:
the first reference image and the second reference image are obtained using a reference beam current; and
the sample image is obtained using a sample beam current;
wherein the reference beam current is higher than the sample beam current.

10. A charged particle assessment method according to any of the preceding claims further comprising:
generating a new reference image by combining the sample image and one of the first reference image and the second reference image;
obtaining a further sample image from a further region of the sample using the charged particle assessment apparatus; and
comparing the further sample image to the new reference image to identify any candidate defects in the further region.

11. A charged particle assessment method according to claim 10 wherein generating a new reference image comprises calculating an average, desirably a weighted average, of the sample image and one of the first reference image and the second reference image.

12. A charged particle assessment method according to claim 10 or 11 further comprising repeating the steps of generating a new reference image; obtaining a further sample image and comparing the further sample image.

13. A charged particle assessment method according to any of the preceding claims wherein the first reference image and the second reference image have a reference signal to noise ratio and the sample image has a sample signal to noise ratio, wherein the reference signal to noise ratio is higher than the sample signal to noise ratio.

14. A charged particle assessment apparatus for identifying candidate defects in a sample by scanning a charged particle beam across the sample; the apparatus comprising:
a detector unit configured to output a digital detection signal of pixel values in response to signal particles incident from the sample;
a scanning unit for relatively scanning the sample and the charged particle beam;
a controller configured to control the detector unit and the scanning unit to obtain a first reference image from a first region of a sample and a second reference image from a second region of the sample and to obtain a sample image from a third region of the sample; and
a comparator configured to compare the sample image to the first reference image and to the second reference image to identify any candidate defects in the third region;
wherein the first reference image and/or the second reference image are obtained with a higher fidelity than the sample image.

15. A charged particle assessment apparatus according to claim 14 wherein the controller is configured to control the detector unit and the scanning unit to:
obtaining the first reference image and the second reference image by relatively scanning the sample and the charged particle beam at a reference scanning rate;
obtaining the sample image by relatively scanning the sample and the charged particle beam at a sample scanning rate; and
the reference scanning rate is slower than the sample scanning rate such that the reference image has a higher fidelity than the sample image.
